(19) Europäisches Patentamt
European Patent Office
Office européen des brevets

(11) **EP 3 754 346 A1**

(12) **EUROPÄISCHE PATENTANMELDUNG**

(43) Veröffentlichungstag:
**23.12.2020 Patentblatt 2020/52**

(21) Anmeldenummer: **19180420.2**

(22) Anmeldetag: **17.06.2019**

(51) Int Cl.:
*G01R 19/165* (2006.01)     *G01R 31/02* (2006.01)
*H02H 3/44* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Lisa Dräxlmaier GmbH**
**84137 Vilsbiburg (DE)**

(72) Erfinder:
• **Hofinger, Stefan Johann**
**84427 Sankt Wolfgang (DE)**
• **Immel, Alexander**
**84030 Ergolding (DE)**
• **Pfeiffer, Michael**
**80997 München (DE)**

(54) **DETEKTIONSVORRICHTUNG, SCHALTVORRICHTUNG, ELEKTRISCHES VERSORGUNGSSYSTEM, DETEKTIONSVERFAHREN UND VERFAHREN**

(57) Die vorliegende Erfindung offenbart eine Detektionsvorrichtung (100, 200) zur Erkennung eines Kurzschlusses in einem Lastpfad (150), aufweisend einen Eingangsanschluss (101, 201) und einen Ausgangsanschluss (102, 202), ein resistives Messelement (103, 203, 303), ein induktives Messelement (104, 204, 304), wobei das resistive Messelement (103, 203, 303) und das induktive Messelement (104, 204, 304) zwischen dem Eingangsanschluss (101, 201) und dem Ausgangsanschluss (102, 202) elektrisch in einer Serienschaltung angeordnet sind, einer Messeinrichtung (105, 205), welche ausgebildet ist, eine Spannung (106, 206) über der Serienschaltung zu messen, und eine Detektionseinrichtung (107, 207), welche mit der Messeinrichtung (105, 205) gekoppelt ist und ausgebildet ist, einen Kurzschluss in dem Lastpfad (150) zu erkennen, wenn die gemessene Spannung (106, 206) einen vorgegebenen Schwellwert überschreitet und ein entsprechendes Kurzschlusssignal (108, 208) auszugeben. Ferner offenbart die vorliegende Erfindung eine Schaltvorrichtung, ein elektrisches Versorgungssystem, ein Detektionsverfahren, ein Verfahren zum Öffnen eines Lastpfads und ein Verfahren zum Versorgen einer elektrischen Last.

Fig. 1

EP 3 754 346 A1

## Beschreibung

### Technisches Gebiet

Die vorliegende Erfindung betrifft eine Detektionsvorrichtung, eine Schaltvorrichtung und ein elektrisches Versorgungssystem. Ferner betrifft die vorliegende Erfindung ein Detektionsverfahren, ein Verfahren zum Öffnen eines Lastpfads und ein Verfahren zum Versorgen einer elektrischen Last.

### Stand der Technik

Die vorliegende Erfindung wird im Folgenden hauptsächlich in Verbindung mit der Überwachung von Energieversorgungssystemen in Fahrzeugen beschrieben. Es versteht sich aber, dass die vorliegende Erfindung auch in anderen Anwendungen eingesetzt werden kann.

In modernen Fahrzeugen kann zur Reduktion der Emissionen ein Elektromotor den Verbrennungsmotor unterstützen, z.B. in Hybridfahrzeugen, bzw. diesen ersetzen, z.B. in Elektrofahrzeugen. Für den Betrieb eines solchen Fahrzeugs mit Elektromotor ist es nötig, in jedem Moment den Betriebszustand des Gesamtsystems aus Energiequelle, also z.B. Batterie, Leistungselektronik und Elektromotor zu kennen. Insbesondere ist es auch nötig, Fehler in dem Gesamtsystem zu erkennen und z.B. bei einem erkannten Kurzschluss die Energiezufuhr zu unterbrechen, um weitere Schäden zu vermeiden.

Bei einem Kurzschluss in einem elektrischen System, wie z.B. dem Antriebsstrang eines Elektrofahrzeugs, steigt der Strom sehr schnell an. Das Auftreten des Kurzschlusses muss folglich ebenfalls sehr schnell erkannt werden, um kritische Stromwerte, die das System schädigen könnten, zu verhindern.

Eine Möglichkeit zur Strommessung bzw. Kurzschlusserkennung ist die DE-SAT-Messung. Hierfür wird die Spannung über dem Halbleiterschalter gemessen. Bei einem IGBT ist dies die Kollektor-Emitter-Sättigungsspannung und bei einem MOSFET der Spannungsabfall über dem Durchgangswiderstand, auch Rdson. Die gemessene Spannung wird über eine Koppeldiode und einen Spannungsteiler an einen Komparatoreingang angelegt. Erreicht die Spannung am Komparator einen eingestellten Schwellwert, wird ein Kurzschluss detektiert. Um die Auslösung bei einem schnellen Stromanstieg zu erhöhen, kann mit Hilfe eines Kondensators ein kapazitiver D-Anteil im Spannungsteiler hinzugefügt werden.

Bei dieser Methode variiert die Kurzschlussschwelle allerdings stark. Verantwortlich hierfür ist vor Allem die Temperaturabhängigkeit der Koppeldiode und des halbleiterbasierten Trennelements. Bei MOSFETs für Hochvoltanwendungen variiert der Rdson im Temperaturbereich 25°C - 150°C um ca. 150%. Zudem nimmt durch Alterung der Übergangswiderstand zwischen dem Silizium und den metallischen Anschlüssen innerhalb des Halbleitergehäuses zu.

### Beschreibung der Erfindung

Eine Aufgabe der Erfindung ist es daher, unter Einsatz konstruktiv möglichst einfacher Mittel eine sichere und schnelle Kurzschlusserkennung zu ermöglichen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Eine erfindungsgemäße Detektionsvorrichtung zur Erkennung eines Kurzschlusses in einem Lastpfad weist auf: einen Eingangsanschluss und einen Ausgangsanschluss, ein resistives Messelement, ein induktives Messelement, wobei das resistive Messelement und das induktive Messelement zwischen dem Eingangsanschluss und dem Ausgangsanschluss elektrisch in einer Serienschaltung angeordnet sind, einer Messeinrichtung, welche ausgebildet ist, eine Spannung über der Serienschaltung zu messen, und eine Detektionseinrichtung, welche mit der Messeinrichtung gekoppelt ist und ausgebildet ist, einen Kurzschluss in dem Lastpfad zu erkennen, wenn die gemessene Spannung einen vorgegebenen Schwellwert überschreitet und ein entsprechendes Kurzschlusssignal auszugeben.

Eine erfindungsgemäße Schaltvorrichtung zum Öffnen eines Lastpfads bei Auftreten eines Kurzschlusses in dem Lastpfad weist auf: einen Leistungseingangsanschluss und einen Leistungsausgangsanschluss, eine erfindungsgemäße Detektionsvorrichtung, und eine steuerbare Schalteinrichtung, welche elektrisch in einer Serienschaltung mit der Detektionsvorrichtung zwischen dem Leistungseingangsanschluss und dem Leistungsausgangsanschluss angeordnet ist und welche kommunikativ mit der Detektionseinrichtung der Detektionsvorrichtung gekoppelt ist und ausgebildet ist, basierend auf dem Kurzschlusssignal einen Stromfluss in der Serienschaltung gesteuert zu unterbrechen.

Ein erfindungsgemäßes elektrisches Versorgungssystem zur Versorgung einer elektrischen Last mit elektrischer Energie weist auf eine Energiequelle, und eine erfindungsgemäße Schaltvorrichtung, wobei die Schaltvorrichtung elektrisch zwischen der Energiequelle und der Last angeordnet ist.

Ein erfindungsgemäßes Detektionsverfahren zum Erkennen eines Kurzschlusses in einem Lastpfad weist die folgenden Schritte auf: Führen eines Stroms in dem Lastpfad über ein resistives Messelement und ein induktives Messelement, wobei das resistive Messelement und das induktive Messelement elektrisch in einer Serienschaltung angeordnet sind, Messen einer Spannung über der Serienschaltung, und Erkennen eines Kurzschlusses in dem Lastpfad, wenn die gemessene Spannung einen vorgegebenen Schwellwert überschreitet.

Ein erfindungsgemäßes Verfahren zum Öffnen eines Lastpfads bei Auftreten eines Kurzschlusses in dem Lastpfad weist die folgenden Schritte auf: Erkennen eines Kurzschlusses mit einem erfindungsgemäßen Detektionsverfahren, und Ansteuern einer steuerbaren Schalteinrichtung, welche elektrisch in einer Serienschaltung mit der Serienschaltung aus resistivem Messelement und induktivem Messelement angeordnet ist, um bei Erkennen eines Kurzschlusses den Stromfluss in der Serienschaltung zu unterbrechen.

Ein erfindungsgemäßes Verfahren zum Versorgen einer elektrischen Last mit elektrischer Energie in einem Versorgungssystem weist die folgenden Schritte auf: Versorgen der elektrischen Last aus einer Energiequelle, und Öffnen des Lastpfads bei Auftreten eines Kurzschlusses in dem Lastpfad mit einem erfindungsgemäßen Verfahren zum Öffnen eines Lastpfads.

Die vorliegende Erfindung basiert auf der Erkenntnis, dass eine bekannte Strommessung für die Kurzschlusserkennung insbesondere in Elektrofahrzeugen nicht zuverlässig bzw. schnell genug ist. Insbesondere kann durch eine solche Kurzschlusserkennung in Anwendungen, wie z.B. Elektrofahrzeugen, nicht sichergestellt werden, dass der Stromfluss schnell genug unterbrochen wird. Schäden an Elementen des Stromkreises können die Folge sein.

Auf Grund der hohen Spannung von mehreren hundert Volt in elektrischen Antriebssystemen steigt im Kurzschlussfall der Kurzschlussstrom im System sehr schnell an. Der Stromanstieg kann genähert mit folgender Formel beschrieben werden:

$$dI / dt = U\_b / L\_sys$$

wobei di/dt die Änderung des Stroms pro Zeiteinheit darstellt, U_b der Batteriespannung entspricht und L_sys die Systeminduktivität ist.

Der Anstieg des Stroms hängt also im Wesentlichen von der Batteriespannung und der Systeminduktivität ab. Ohmsche Anteile werden der Einfachheit halber hier vernachlässigt. In Abhängigkeit vom Kurzschlussort ändert sich in einem elektrischen Antriebssystem die im Kurzschlussfall relevante Induktivität. Tritt der Kurzschluss z.B. nahe der Batterie auf, ist nur die Batterieinduktivität und ein geringer Anteil der Leitungsinduktivität Bestandteil des Kurzschlusskreises. Tritt der Kurzschluss dagegen z.B. in einer Last auf, sind die Batterieinduktivität die Leitungsinduktivität und die Lastinduktivität Teil des Kurzschlusskreises.

Somit kann der Stromanstieg im Kurzschlussfall sehr stark variieren. Bis zur Erkennung eines Kurzschlusses vergeht eine bestimmte Zeit. Auf Grund der dadurch entstehenden Ausschaltverzögerung kann sich in Abhängigkeit von der relevanten Induktivität folglich ein höherer zu trennender Strom ergeben, als erwünscht. Der zu trennende Strom ergibt sich zu:

$$I\_trenn = I\_schwelle + di / dt * T$$

wobei I_trenn der Strom ist, bei welchem der Lastpfad geöffnet wird, I_schwelle der eigentlich vorgegebene Trennstrom ist und T die Verzögerung beim Abschalten darstellt. Die Verzögerung ergibt sich aus der (optionalen) Filterung, der Komparatorschaltung und der Abschaltverzögerung des Halbleiters. Beispielhaft kann die tatsächliche Stromschwelle bei folgenden Werten liegen:

hochinduktiver Kurzschluss:

$$100 \text{ A} + 35 \text{ kA/ms} * 750 \text{ ns} = 126 \text{ A}$$

niederinduktiver Kurzschluss:

$$100 \text{ A} + 150 \text{ kA/ms} * 750 \text{ ns} = 213 \text{ A}$$

Bei diesen Beispielen wird ein Schwellwert für eine Kurzschlusserkennung von 100A angenommen. Die beiden Beispiele verdeutlichen, dass bei einem niederinduktiven Kurzschluss der zu trennende Strom deutlich höher ist, als bei einem hochinduktiven Kurzschluss. Der Schwellwert für die Kurzschlusserkennung kann aber nicht beliebig klein gewählt werden, da ansonsten im normalen Betrieb eine zu frühe bzw. falsche Kurzschlusserkennung erfolgen könnte.

Die vorliegende Erfindung ermöglicht mit der Detektionsvorrichtung zur Erkennung eines Kurzschlusses eine sehr schnelle Kurzschlusserkennung, ohne dass dazu der Schwellwert für die Kurzschlusserkennung abgesenkt werden müsste.

Im Gegensatz zu herkömmlichen Messverfahren, bei welchen üblicherweise versucht wird, Induktivitäten weitestgehend auszuschließen, wird in der Detektionsvorrichtung bewusst ein induktives Messelement mit einem resistiven Messelement in Serie angeordnet. Der Begriff Messelement bezieht sich hierbei auf die einzelnen Elemente, über denen ein Spannungsabfall gemessen wird, um einen Strom zu messen.

Das resistive Messelement und das induktive Messelement sind in einer Serienschaltung angeordnet. Der in dem Lastpfad fließende Strom wird über eine Spannungsmessung der Spannung bestimmt, die über dieser Serienschaltung abfällt. Zur Messung des Stroms wird die Spannung über der Serienschaltung durch die Messeinrichtung erfasst und in der Detektionseinrichtung ausgewertet. Liegt die gemessene Spannung über einem vorgegebenen Schwellwert, gibt die Detektionseinrichtung ein entsprechendes Kurzschlusssignal aus.

Aus den obigen Erläuterungen wird deutlich, dass der Begriff "Messelement" sich auf ein passives elektrisches bzw. elektronisches Element beziehen kann, über welchem bei Stromfluss eine Spannung abfällt.

Die Spannung ergibt sich gemäß folgender Formel:

$$U = R * I + L * (di / dt)$$

wobei R der Widerstandswert des resistiven Messelements ist, L die Induktivität des induktiven Messelements ist, I den momentan fließenden Strom darstellt und di/dt die Änderung des Stroms pro Zeiteinheit darstellt.

Tritt bei Verwendung der erfindungsgemäßen Detektionsvorrichtung ein niederinduktiver Kurzschluss auf, steigt der Strom in dem Lastpfad sehr schnell an. Folglich wird der Koeffizient di / dt ebenfalls sehr groß und der induktive bzw. D-Anteil, auch differentieller Anteil genannt, verursacht durch L * di / dt einen großen Anteil an der zu messenden Spannung.

Im normalen Betrieb dagegen ist immer die gesamte Induktivität des Lastpfads aktiv. Somit wird die Stromänderung di / dt deutlich geringer und der induktive bzw. D-Anteil sehr klein. Damit ist sichergestellt, dass im normalen Betrieb keine Falschauslösung erfolgt.

Folgende Beispielrechnungen zeigen das Verhalten der erfindungsgemäßen Detektionsvorrichtung mit induktivem Messelement:

Für die Ausgangssituation seien folgende Werte angenommen:

I = 20 A (Vor dem Auftreten des Kurzschlusses, Stromaufnahme der Nebenaggregate)
L_sys1 = 3 $\mu$H (Kurzschluss nahe der Batterie)
L_sys2 = 13 $\mu$H (Kurzschluss in der Last)
U_bat = 450 V (Versorgungsspannung in dem Lastpfad)
L_mess = 1 nH (Induktivität des induktiven Messelements)
U_komp = 200 mV (Auslöseschwelle der Kurzschlusserkennung)
R_shunt = 2 mOhm (Widerstandswert des resistiven Messelements)

Kurzschluss nahe der Batterie:

Auslöseschwelle:

$$U\_schwelle = 25 A * 2 mOhm + 1 nH * 150 kA / ms = 200 mV$$

Detektionszeit:

$$5 A * 6,7ns / A = 34 ns$$

Trennstrom:

$$25\ A + 150\ kA\ /\ ms * 750\ ns = \underline{138\ A}\ \text{(vgl. 213 A ohne D-Anteil)}$$

Kurzschluss nahe dem Verbraucher

Auslöseschwelle:

$$U\_schwelle = 82,5\ A * 2\ mOhm + 1\ nH * 35\ kA\ /\ ms = 200\ mV$$

Detektionszeit:

$$62,5\ A * 28,9\ ns\ /\ A = 1,81\ \mu s$$

Trennstrom:

$$82,5\ A + 35\ kA\ /\ ms * 750\ ns = \underline{109\ A}\ \text{(vgl. 126 A ohne D-Anteil)}$$

Die obigen Beispielrechnungen zeigen deutlich, dass der tatsächliche Abschaltstrom dank der gezielt eingebrachten Induktivität des induktiven Messelements deutlich näher an der vorgegebenen Abschaltschwelle von 100 A liegt.

Mit Hilfe der Detektionsvorrichtung kann folglich ein Stromanstieg sehr schnell erfasst werden. Wird die Detektionsvorrichtung in einer erfindungsgemäßen Schaltvorrichtung eingesetzt, kann die steuerbare Schalteinrichtung sehr rasch nach dem Auftreten eines Kurzschlusses angesteuert werden.

Das induktive Messelement kann z.B. als dediziertes Bauteil, z.B. eine Spule oder andere Form der Induktivität ausgebildet sein. Das induktive Messelement kann z.B. auch als Leiterbahnenstruktur oder als entsprechende, gezielte Modifikation des resistiven Messelements ausgebildet sein.

Bei der erfindungsgemäßen Schaltvorrichtung kann die Detektionsvorrichtung ausgangsseitig angeordnet sein. Der Leistungseingangsanschluss der Schaltvorrichtung kann mit einer Energiequelle gekoppelt sein. Der Leistungsausgangsanschluss kann mit der Last gekoppelt sein. Die Detektionsvorrichtung kann dabei elektrisch zwischen steuerbarer Schalteinrichtung und Leistungsausgangsanschluss angeordnet sein.

Ein schnelles Ansteuern bzw. Auslösen der steuerbaren Schalteinrichtung kann bei einer Kurzschlusserkennung die Komplexität der notwendigen Schutzbeschaltung für Halbleiterschalter in der steuerbaren Schalteinrichtung deutlich reduzieren.

In einem erfindungsgemäßen elektrischen Versorgungssystem kann folglich sehr schnell auf einen Fehler reagiert werden und weitere Schäden in dem System bzw. der Anwendung verhindert werden.

Weitere Ausführungsformen und Weiterbildungen ergeben sich aus den Unteransprüchen sowie aus der Beschreibung unter Bezugnahme auf die Figuren.

In einer weiteren Ausführungsform kann ein Filterelement zwischen der Serienschaltung in der Messeinrichtung angeordnet sein. Das Filterelement kann ausgebildet sein, die zu messende Spannung zu filtern.

Ein Filtern der zu messenden Spannung ermöglicht es, die Kurzschlusserkennung unabhängig gegen Störeinflüsse zu gestallten. Solche Störeinflüsse können insbesondere bei Antriebssystemen für Fahrzeuge z.B. durch das getaktete Schalten induktiver Lasten, wie Elektromotoren, entstehen. Ferner kann mit der Filterung die Auslösecharakteristik angepasst werden.

In einer weiteren Ausführungsform kann das induktive Messelement eine Induktivität von 0,5 nH bis 4 nH aufweisen, insbesondere 1 nH oder 2 nH oder 3 nH. Das resistive Messelement kann einen Widerstand von 0,5 mOhm, Milliohm, bis 10 mOhm aufweisen.

Das resistive Messelement kann als Shunt-Widerstand ausgebildet sein. Ein solcher Shunt-Widerstand soll einen möglichst kleinen aber exakt definierten Widerstandswert haben. Da über den Shunt-Widerstand eine Spannung in Abhängigkeit von dem durch den Shunt-Widerstand fließenden Strom abfällt, kann der Widerstandswert des Shunt-Widerstands an die jeweilige Anwendung bzw. den jeweils zu messenden Strom angepasst werden.

Das induktive Messelement kann ebenfalls an die jeweilige Anwendung angepasst werden. Insbesondere kann das induktive Messelement z.B. in Abhängigkeit der in der Anwendung zu erwartenden Stromgradienten und der gewünschten Spannungserhöhung dimensioniert werden. Die zu erwartenden Stromgradienten können für die jeweilige Anwendung z.B. simuliert oder an einem Versuchsaufbau gemessen werden.

In noch einer weiteren Ausführungsform kann die steuerbare Schalteinrichtung eine Anzahl, also eine oder mehrere, von halbleiterbasierten Schalteinheiten aufweisen, welche jeweils einen Leistungseingang und einen Leistungsausgang und einen Steuereingang aufweisen und deren Lastpfade bei Vorhandensein mehrerer halbleiterbasierter Schalteinheiten elektrisch parallel zueinander angeordnet sind.

In üblichen Sicherungseinrichtungen für Fahrzeuganwendungen werden häufig Schmelzsicherungen oder mechanische Schaltelemente, wie Relais eingesetzt. Dies ist insbesondere der Tatsache geschuldet, dass mit herkömmlichen Messverfahren, wie oben erläutert, ein Kurzschluss nur sehr langsam bzw. spät erkannt werden kann.

Da mit Hilfe der erfindungsgemäßen Detektionsvorrichtung ein Kurzschluss sehr schnell erkannt werden kann, wird der Einsatz von halbleiterbasierten Schaltelementen möglich, ohne dass komplexe Schutzbeschaltungen vorgesehen werden müssen. Die halbleiterbasierten Schaltelemente können z.B. als MOSFETs oder IGBTs ausgebildet sein. Die Anzahl der halbleiterbasierten Schalteinheiten kann in Abhängigkeit von den maximal in dem Lastpfad auftretenden Strömen an die jeweilige Anwendung angepasst werden.

In einer weiteren Ausführungsform kann die steuerbare Schalteinrichtung ein Treiberelement aufweisen, welches ausgebildet sein kann, die halbleiterbasierten Schalteinheiten mit einer vorgegebenen positiven Spannung anzusteuern, um die halbleiterbasierten Schalteinheiten zu schließen, und die halbleiterbasierten Schalteinheiten mit einer vorgegebenen negativen Spannung anzusteuern, um die halbleiterbasierten Schalteinheiten zu öffnen.

Bei der erfindungsgemäßen Schaltvorrichtung kann die Induktivität des induktiven Messelements einen Einfluss auf die Gate-Ansteuerung der halbleiterbasierten Schaltelemente haben.

Ist die Detektionsvorrichtung elektrisch zwischen steuerbarer Schalteinrichtung und Leistungsausgangsanschluss angeordnet, liegt das Bezugspotential für die Messung der Spannung und die Ansteuerung der steuerbaren Schalteinrichtung in dem Lastpfad nach dem Shunt, also zwischen Schaltvorrichtung und Last. Dadurch liegt auch die Induktivität des induktiven Messelements im Gate-Ansteuerkreis. Beim Abschalten bzw. Entladen der Gatekapazität kann es daher zu einer Anhebung der Gate-Source-Spannung kommen. Dies könnte zu einem erneuten Einschalten der halbleiterbasierten Schalteinheit führen.

Um einen Einfluss dieser Induktivität zu vermeiden, wird häufig ein Kelvin-Source bzw. Kelvin-Connection zur Ansteuerung des jeweiligen Schaltelements verwendet. Dies ist bei der vorliegenden Erfindung aber nicht nötig.

Da im vorliegenden Anwendungsfall Lasten dauerhaft zu oder abgeschaltet werden, ist bei der Schaltvorrichtung kein schnelles zyklisches Schalten nötig, wie z.B. in Wechselrichtern, somit ist der negative Einfluss der Induktivität im Gate-Ansteuerkreis nicht relevant. Folglich kann sehr einfach durch die Verwendung einer negativen Spannung zum Ansteuern der halbleiterbasierten Schalteinheiten dem Spannungsabfall über den Induktivitäten im Ausschaltmoment effektiv entgegengewirkt werden.

In noch einer weiteren Ausführungsform kann der Betrag der negativen Spannung derart ausgebildet sein, dass er größer ist, als der Betrag eines durch eine Systeminduktivität des Versorgungssystems in dem Versorgungssystem erzeugten Spannungsanstiegs an den Leistungseingängen und Steuereingängen der halbleiterbasierten Schalteinheiten.

## Kurze Figurenbeschreibung

Nachfolgend werden vorteilhafte Ausführungsbeispiele der Erfindung unter Bezugnahme auf die begleitenden Figuren erläutert. Es zeigen:

Figur 1 ein Blockschaltbild eines Ausführungsbeispiels einer Detektionsvorrichtung gemäß der vorliegenden Erfindung;

Figur 2 ein Blockschaltbild eines Ausführungsbeispiels einer Schaltvorrichtung gemäß der vorliegenden Erfindung;

Figur 3 ein Blockschaltbild eines Ausführungsbeispiels eines Versorgungssystems gemäß der vorliegenden Erfindung;

Figur 4 ein Ablaufdiagramm eines Ausführungsbeispiels eines Detektionsverfahrens gemäß der vorliegenden Erfindung;

Figur 5 ein Ablaufdiagramm eines Ausführungsbeispiels eines Verfahrens zum Öffnen eines Lastpfads gemäß der vorliegenden Erfindung; und

Figur 6 ein Ablaufdiagramm eines Ausführungsbeispiels eines Verfahrens zum Versorgen einer elektrischen Last gemäß der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

## Detaillierte Beschreibung

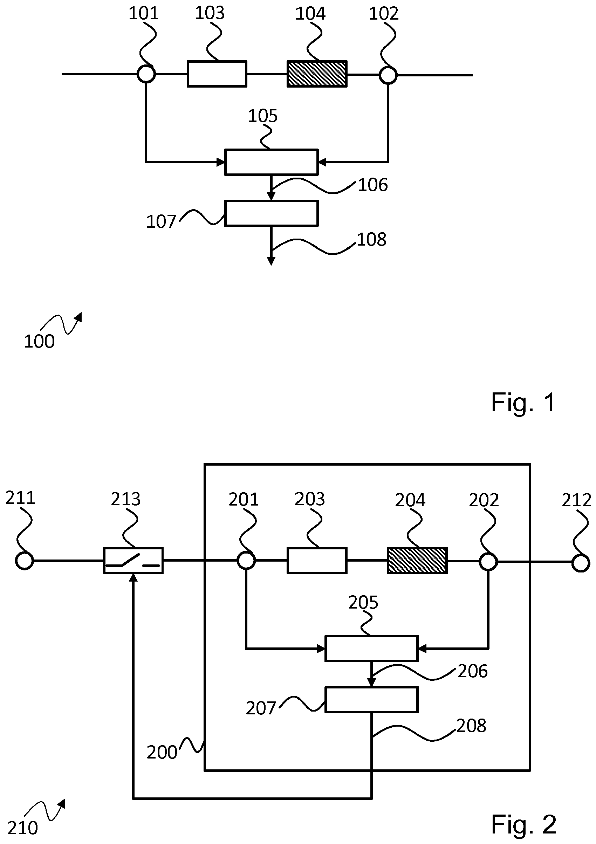

Figur 1 zeigt ein Blockschaltbild einer Detektionsvorrichtung 100. Die Detektionsvorrichtung 100 weist einen Eingangsanschluss 101 und einen Ausgangsanschluss 102 auf, über welche die Detektionsvorrichtung 100 elektrisch in einem Lastpfad 150 angeordnet werden kann und in diesem zur Erkennung eines Kurzschlusses genutzt werden kann.

Die Detektionsvorrichtung 100 weist ein resistives Messelement 103 und ein induktives Messelement 104 auf. Das resistive Messelement 103 und das induktive Messelement 104 sind in einer Serienschaltung zwischen dem Eingangsanschluss 101 und dem Ausgangsanschluss 102 angeordnet. Ferner ist eine Messeinrichtung 105 vorgesehen.

Die Messeinrichtung 105 ist elektrisch mit dem Eingangsanschluss 101 und dem Ausgangsanschluss 102 gekoppelt, um eine Spannung 106 über der Serienschaltung aus resistivem Messelement 103 und induktivem Messelement 104 zu messen.

Die Detektionseinrichtung 107 ist mit der Messeinrichtung 105 gekoppelt und erkennt einen Kurzschluss in dem Lastpfad 150, wenn die gemessene Spannung 106 einen vorgegebenen Schwellwert überschreitet. Erkennt die Detektionseinrichtung 107 einen Kurzschluss, gibt sie ein entsprechendes Kurzschlusssignal 108 aus.

Es versteht sich, dass die Detektionseinrichtung 107 und die Messeinrichtung 105 z.B. als dedizierte Elemente ausgebildet sein können, z.B. als Komparator und A/D-Wandler. Ferner können die Detektionseinrichtung 107 und die Messeinrichtung 105 z.B. als ein Mikrocontroller, Prozessor, ASIC, FPGA oder dergleichen mit entsprechenden Schnittstellen und einer entsprechenden Programmkomponente ausgebildet sein.

Die Induktivität des induktiven Messelements 104 kann an die jeweilige Anwendung und z.B. an die zu erwartenden Stromgradienten in der jeweiligen Anwendung angepasst werden. Beispielsweise kann das induktive Messelement 104 eine Induktivität von 0,5 nH bis 4 nH aufweisen. Gleiches gilt für das resistive Messelement 103. Diese kann als Shunt-Widerstand z.B. einen Widerstand von 0,5 mOhm bis 10 mOhm aufweisen.

Es versteht sich, dass der vorgegebene Schwellwert als Spannungsschwellwert angegeben werden kann, da die gemessene Spannung über der Serienschaltung den Strom über der Serienschaltung kennzeichnet. Es versteht sich ferner, dass z.B. auch ein Stromschwellwert vorgegeben werden kann. Die gemessene Spannung kann beispielsweise in einer Steuer- oder Recheneinheit in den entsprechenden Strom umgerechnet werden. Dieser Wert kann anschließend mit dem Stromschwellwert verglichen werden.

Wie oben bereits erläutert, kann mit Hilfe des induktiven Messelements 104 ein rascher Stromanstieg deutlich schneller erkannt werden, als nur mit einem herkömmlichen resistiven Messelement 103. Die Detektionsvorrichtung 100 kann folglich einen Stromanstieg und damit einen Kurzschluss in dem Lastpfad 150 sehr schnell erkennen.

Figur 2 zeigt ein Blockschaltbild eines Ausführungsbeispiels einer Schaltvorrichtung 210. Die Schaltvorrichtung 210 weist einen Leistungseingangsanschluss 211 und einen Leistungsausgangsanschluss 212 auf. Zwischen dem Leistungseingangsanschluss 211 und dem Leistungsausgangsanschluss 212 ist eine steuerbare Schalteinrichtung 213 elektrisch in einer Serienschaltung mit einer Detektionsvorrichtung 200 angeordnet. Ein Steuereingang der steuerbaren Schalteinrichtung 213 ist mit dem Ausgang der Detektionsvorrichtung 200 gekoppelt, über welchen das Kurzschlusssignal 208 ausgegeben wird.

Die Detektionsvorrichtung 200 ist gemäß Figur 1 aufgebaut. Es versteht sich, dass jede andere Ausführungsform einer erfindungsgemäßen Detektionsvorrichtung anstelle der Detektionsvorrichtung 200 genutzt werden kann.

Die steuerbare Schalteinrichtung 213 kann z.B. eines oder mehrere halbleiterbasierte Schalteinheiten, z.B. MOSFETs oder IGBTs, aufweisen. Die halbleiterbasierten Schalteinheiten selbst können jeweils einen Leistungseingang und einen Leistungsausgang sowie einen Steuereingang aufweisen. Die Lastpfade der halbleiterbasierten Schalteinheiten können elektrisch parallel zueinander angeordnet sein.

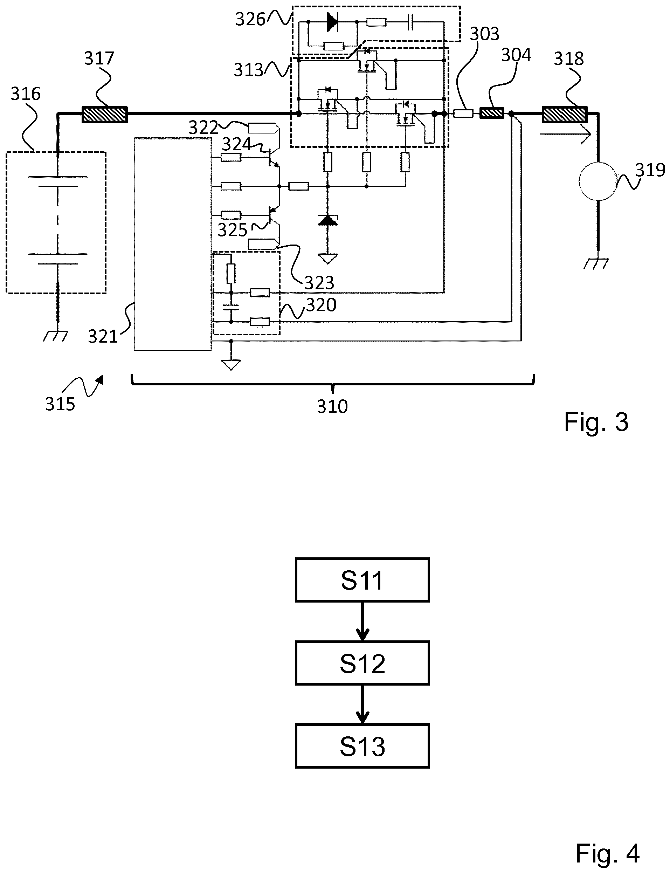

In einer Ausführung kann die steuerbare Schalteinrichtung 213 ein Treiberelement bzw. einen Treiberbaustein aufweisen (siehe Figur 3). Dieses Treiberelement kann die halbleiterbasierten Schalteinheiten mit einer vorgegebenen positiven Spannung ansteuern, um die halbleiterbasierten Schalteinheiten zu schließen bzw. durchzuschalten. Das Treiberelement kann die halbleiterbasierten Schalteinheiten mit einer vorgegebenen negativen Spannung ansteuern, um die halbleiterbasierten Schalteinheiten zu öffnen, also einen Stromfluss in dem Lastpfad zu unterbrechen.

Figur 3 zeigt ein Blockschaltbild eines elektrischen Versorgungssystems 315 zur Versorgung einer elektrischen Last 319 mit elektrischer Energie.

Das elektrische Versorgungssystem 315 weist eine Energiequelle 316 auf. Die Energiequelle 316 kann z.B. als Hochvoltbatterie für eine Elektrofahrzeug ausgebildet sein. Ferner ist eine Schaltvorrichtung 310 elektrisch zwischen der Energiequelle 316 und der Last 319 angeordnet. In Figur 3 sind die in dem elektrischen Versorgungssystems 315 vorhandenen Induktivitäten als Leitungsinduktivität 317 zwischen Energiequelle 316 und Schaltvorrichtung 310 sowie als Leitungsinduktivität 318 zwischen Schaltvorrichtung 310 und Last 319 dargestellt. Üblicherweise wird die Leitungsinduktivität 317 sehr klein ausfallen, da die Schaltvorrichtung 310 nahe der Energiequelle 316 angeordnet wird. Bei einem Kurzschluss nahe der Schaltvorrichtung 310 ist daher lediglich eine geringe Induktivität wirksam.

Die Schaltvorrichtung 310 weist als steuerbare Schalteinrichtung 313 eine Parallelschaltung aus drei MOSFETs auf (der Übersichtlichkeit halber nicht separat mit einem Bezugszeichen versehen). Es ist zu erkennen, dass die Kelvin-Source- oder Kelvin-Connection-Anschlüsse der MOSFETs nicht genutzt werden. Dies ist wie oben erläutert nicht nötig. Parallel zu der steuerbaren Schalteinrichtung 313 ist eine Schutzbeschaltung 326 vorgesehen, welche die MOSFETs z.B. vor Spannungsspitzen schützt.

Das resistive Messelement 303 ist in einer Serienschaltung mit dem induktiven Messelement 304 zwischen der steuerbaren Schalteinrichtung 313 und der Last 319 angeordnet.

Ein Treiberelement 321 ist vorgesehen, welches auch die Funktionen der Messeinrichtung und der Detektionseinrichtung ausführt. Zwischen den Messeingängen des Treiberelements 321 und der Serienschaltung aus resistivem Messelement 303 und induktivem Messelement 304 ist ein Filterelement 320, hier ein RC-Filter vorgesehen. Es versteht sich, dass als Filterelement 320 jede Schaltung eingesetzt werden kann, welche die gewünschten Filterergebnisse liefert. Ferner kann das Filterelement 320 auch zur Anpassung der Auslösecharakteristik, also zur Anpassung der gemessenen Spannung, genutzt werden.

Um ein sicheres Abschalten, also Öffnen, der MOSFETs in der steuerbaren Schalteinrichtung 313 zu gewährleisten, kann das Treiberelement 321 die Steuereingänge der MOSFETs über Schalteinheiten 324, 325 entweder mit einer positiven Spannung 322 oder mit einer negativen Spannung 323 beaufschlagen.

Der Betrag der negativen Spannung 323 kann dabei derart bestimmt werden, dass er größer ist, als der Betrag eines durch eine Systeminduktivität des Versorgungssystems 315 in dem Versorgungssystem 315 erzeugten Spannungsanstiegs an den Leistungseingängen und Steuereingängen der MOSFETs.

Der Übersichtlichkeit halber nicht separat mit Bezugszeichen versehen sind die Widerstände und weitere Elemente, des Ansteuernetzwerks für die MOSFETs. Es versteht sich, dass jede geeignete Form der Beschaltung zwischen der steuerbaren Schalteinrichtung 313 und Treiberelement 321 gewählt werden kann, die ein sicheres Einschalten und Ausschalten der Schalteinheiten in der steuerbaren Schalteinrichtung 313 ermöglicht.

Zum leichteren Verständnis werden in der folgenden Beschreibung die Bezugszeichen zu den Figuren 1-3 als Referenz beibehalten.

Figur 4 zeigt ein Ablaufdiagramm eines Ausführungsbeispiels eines Detektionsverfahrens zum Erkennen eines Kurzschlusses in einem Lastpfad 150:

In einem ersten Schritt S11 des Führens wird ein Strom in dem Lastpfad 150 über ein resistives Messelement 103, 203, 303 und ein induktives Messelement 104, 204, 304 geführt, wobei das resistive Messelement 103, 203, 303 und das induktive Messelement 104, 204, 304 elektrisch in einer Serienschaltung angeordnet sind. In einem zweiten Schritt S12 des Messens wird eine Spannung 106, 206 über der Serienschaltung gemessen. In einem dritten Schritt S13 des Erkennens wird ein Kurzschluss in dem Lastpfad 150 erkannt, wenn die gemessene Spannung 106, 206 einen vorgegebenen Schwellwert überschreitet.

Als induktives Messelement 104, 204, 304 kann z.B. ein induktives Messelement 104, 204, 304 mit einer Induktivität von 0,5 nH bis 4 nH genutzt werden. Als resistives Messelement 103, 203, 303 kann ein resistives Messelement 103, 203, 303 mit einem Widerstand von 0,5 mOhm bis 10 mOhm genutzt werden.

Vor dem zweiten Schritt S12 kann optional ein Filtern der zu messenden Spannung 106, 206 erfolgen.

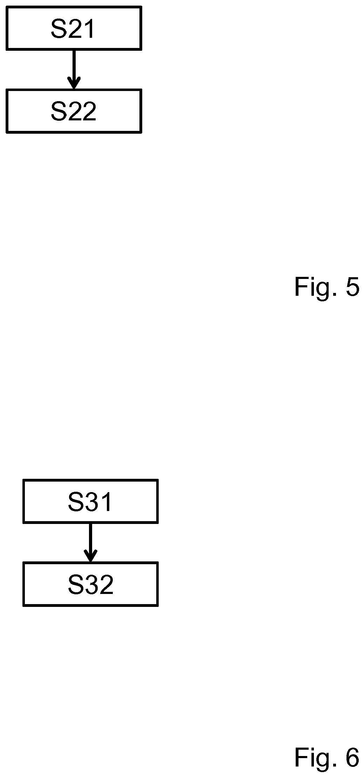

Figur 5 zeigt ein Ablaufdiagramm eines Ausführungsbeispiels eines Verfahrens zum Öffnen eines Lastpfads 150 bei Auftreten eines Kurzschlusses in dem Lastpfad 150.

In einem ersten Schritt S21 des Erkennens wird ein Kurzschluss mit einem erfindungsgemäßen Detektionsverfahren, z.B. gemäß Figur 4, erkannt. In einem zweiten Schritt S22 des Ansteuerns wird eine steuerbare Schalteinrichtung 213, 313, welche elektrisch in einer Serienschaltung mit der Serienschaltung aus resistivem Messelement 103, 203, 303 und induktivem Messelement 104, 204, 304 angeordnet ist, angesteuert, um bei Erkennen eines Kurzschlusses den Stromfluss in der Serienschaltung zu unterbrechen.

In der steuerbaren Schalteinrichtung 213, 313 kann z.B. eine Anzahl von halbleiterbasierten Schalteinheiten, z.B. MOSFETs oder IGBTs oder dergleichen, angesteuert werden, welche jeweils einen Leistungseingang und einen Leistungsausgang und einen Steuereingang aufweisen und deren Lastpfade 150 bei Vorhandensein mehrerer halbleiterbasierter Schalteinheiten elektrisch parallel zueinander angeordnet sind.

Die halbleiterbasierten Schalteinheiten können z.B. mit einer vorgegebenen positiven Spannung 322 angesteuert werden, um die halbleiterbasierten Schalteinheiten zu schließen. Um die halbleiterbasierten Schalteinheiten zu öffnen, können diese mit einer vorgegebenen negativen Spannung 323 angesteuert werden.

Figur 6 zeigt ein Ablaufdiagramm eines Ausführungsbeispiels eines Verfahrens zum Versorgen einer elektrischen Last 319 mit elektrischer Energie in einem Versorgungssystem 315.

In einem ersten Schritt S31 des Versorgens wird die elektrische Last 319 aus einer Energiequelle 316 mit elektrischer Energie versorgt. In einem zweiten Schritt S32 des Öffnens wird der Lastpfad 150 bei Auftreten eines Kurzschlusses in dem Lastpfad 150 mit einem erfindungsgemäßen Verfahren zum Öffnen eines Lastpfads 150, z.B. gemäß Figur 5, geöffnet.

Der Betrag der in Figur 5 erwähnten negativen Spannung 323 kann dabei derart gewählt werden, dass er größer ist, als der Betrag eines durch eine Systeminduktivität des Versorgungssystems 315 in dem Versorgungssystem 315 erzeugten Spannungsanstiegs an den Leistungseingängen und Steuereingängen der halbleiterbasierten Schalteinheiten, z.B. - 8 V.

Da es sich bei der vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

BEZUGSZEICHENLISTE

| | |
|---|---|
| 100, 200 | Detektionsvorrichtung |
| 101, 201 | Eingangsanschluss |
| 102, 202 | Ausgangsanschluss |
| 103, 203, 303 | resistives Messelement |
| 104, 204, 304 | induktives Messelement |
| 105, 205 | Messeinrichtung |
| 106,206 | Spannung |
| 107,207 | Detektionseinrichtung |
| 108, 208 | Kurzschlusssignal |
| | |
| 210,310 | Schaltvorrichtung |
| 211 | Leistungseingangsanschluss |
| 212 | Leistungsausgangsanschluss |
| 213, 313 | steuerbare Schalteinrichtung |
| | |
| 315 | elektrisches Versorgungssystem |
| 316 | Energiequelle |
| 317, 318 | Leitungsinduktivität |
| 319 | Last |
| 320 | Filterelement |
| 321 | Treiberelement |
| 322 | positive Spannung |
| 323 | negative Spannung |
| 324, 325 | Schalteinheit |
| 326 | Schutzbeschaltung |
| | |
| 150 | Lastpfad |
| | |
| S11, S12, S13 | Verfahrensschritte |
| S21, S22, S31, S32 | Verfahrensschritte |

**Patentansprüche**

**1.** Detektionsvorrichtung (100, 200) zur Erkennung eines Kurzschlusses in einem Lastpfad (150), aufweisend:

a) einen Eingangsanschluss (101, 201) und einen Ausgangsanschluss (102, 202),
b) ein resistives Messelement (103, 203, 303),
c) ein induktives Messelement (104, 204, 304), wobei das resistive Messelement (103, 203, 303) und das induktive Messelement (104, 204, 304) zwischen dem Eingangsanschluss (101, 201) und dem Ausgangsanschluss (102, 202) elektrisch in einer Serienschaltung angeordnet sind,
d) eine Messeinrichtung (105, 205), welche ausgebildet ist, eine Spannung (106, 206) über der Serienschaltung zu messen, und
e) eine Detektionseinrichtung (107, 207), welche mit der Messeinrichtung (105, 205) gekoppelt ist und ausgebildet ist, einen Kurzschluss in dem Lastpfad (150) zu erkennen, wenn die gemessene Spannung (106, 206) einen vorgegebenen Schwellwert überschreitet, und ein entsprechendes Kurzschlusssignal (108, 208) auszugeben.

**2.** Detektionsvorrichtung (100, 200) nach Anspruch 1, aufweisend ein Filterelement (320), welches zwischen der Serienschaltung in der Messeinrichtung (105, 205) angeordnet ist und ausgebildet ist, die zu messende Spannung (106, 206) zu filtern.

3. Detektionsvorrichtung (100, 200) nach einem der vorherigen Ansprüche, wobei das induktive Messelement (104, 204, 304) eine Induktivität von 0,5 nH bis 4 nH aufweist, insbesondere 1 nH oder 2 nH oder 3 nH, und/oder wobei das resistive Messelement (103, 203, 303) einen Widerstand von 0,5 mOhm bis 10 mOhm aufweist.

4. Schaltvorrichtung (210, 310) zum Öffnen eines Lastpfads (150) bei Auftreten eines Kurzschlusses in dem Lastpfad (150), aufweisend:

   a) einen Leistungseingangsanschluss (211) und einen Leistungsausgangsanschluss (212),
   b) eine Detektionsvorrichtung (100, 200) nach einem der vorherigen Ansprüche, und
   c) eine steuerbare Schalteinrichtung (213, 313), welche elektrisch in einer Serienschaltung mit der Detektionsvorrichtung (100, 200) zwischen dem Leistungseingangsanschluss (211) und dem Leistungsausgangsanschluss (212) angeordnet ist und welche kommunikativ mit der Detektionseinrichtung (107, 207) der Detektionsvorrichtung (100, 200) gekoppelt ist und ausgebildet ist basierend auf dem Kurzschlusssignal (108, 208) einen Stromfluss in der Serienschaltung gesteuert zu unterbrechen.

5. Schaltvorrichtung (210, 310) nach Anspruch 4, wobei die steuerbare Schalteinrichtung (213, 313) eine Anzahl von halbleiterbasierten Schalteinheiten aufweist, welche jeweils einen Leistungseingang und einen Leistungsausgang und einen Steuereingang aufweisen und deren Lastpfade (150) bei Vorhandensein mehrerer halbleiterbasierter Schalteinheiten elektrisch parallel zueinander angeordnet sind.

6. Schaltvorrichtung (210, 310) nach Anspruch 5, wobei die steuerbare Schalteinrichtung (213, 313) ein Treiberelement (321) aufweist, welches ausgebildet ist, die halbleiterbasierten Schalteinheiten mit einer vorgegebenen positiven Spannung (322) anzusteuern, um die halbleiterbasierten Schalteinheiten zu schließen, und die halbleiterbasierten Schalteinheiten mit einer vorgegebenen negativen Spannung (323) anzusteuern, um die halbleiterbasierten Schalteinheiten zu öffnen.

7. Elektrisches Versorgungssystem (315) zur Versorgung einer elektrischen Last (319) mit elektrischer Energie, aufweisend:

   a) eine Energiequelle (316), und
   b) eine Schaltvorrichtung (210, 310) nach einem der vorherigen Ansprüche 4 bis 6, wobei die Schaltvorrichtung (210, 310) elektrisch zwischen der Energiequelle (316) und der Last (319) angeordnet ist.

8. Elektrisches Versorgungssystem (315) nach Anspruch 7, wobei die Schaltvorrichtung (210, 310) nach Anspruch 6 ausgebildet ist und der Betrag der negativen Spannung (323) derart ausgebildet ist, dass er größer ist, als der Betrag eines durch eine Systeminduktivität des Versorgungssystems (315) in dem Versorgungssystem (315) erzeugten Spannungsanstiegs an den Leistungseingängen und Steuereingängen der halbleiterbasierten Schalteinheiten .

9. Detektionsverfahren zum Erkennen eines Kurzschlusses in einem Lastpfad (150), aufweisend:

   a) Führen (S11) eines Stroms in dem Lastpfad (150) über ein resistives Messelement (103, 203, 303) und ein induktives Messelement (104, 204, 304), wobei das resistive Messelement (103, 203, 303) und das induktive Messelement (104, 204, 304) elektrisch in einer Serienschaltung angeordnet sind,
   b) Messen (S12) einer Spannung (106, 206) über der Serienschaltung, und
   c) Erkennen (S13) eines Kurzschlusses in dem Lastpfad (150), wenn die gemessene Spannung (106, 206) einen vorgegebenen Schwellwert überschreitet.

10. Detektionsverfahren nach Anspruch 9, aufweisend das Filtern der zu messenden Spannung (106, 206) vor dem Messen der Spannung (106, 206).

11. Detektionsverfahren nach einem der vorherigen Ansprüche 9 und 10, wobei als induktives Messelement (104, 204, 304) ein induktive Messelement (104, 204, 304) mit einer Induktivität von 0,5 nH bis 4 nH genutzt wird, insbesondere 1 nH oder 2 nH oder 3 nH, und/oder wobei als resistives Messelement (103, 203, 303) ein resistives Messelement (103, 203, 303) mit einem Widerstand von 0,5 mOhm bis 10 mOhm genutzt wird.

12. Verfahren zum Öffnen eines Lastpfads (150) bei Auftreten eines Kurzschlusses in dem Lastpfad (150), aufweisend:

   a) Erkennen (S21) eines Kurzschlusses mit einem Verfahren nach einem der Ansprüche 9 bis 11,

b) Ansteuern (S22) einer steuerbaren Schalteinrichtung (213, 313), welche elektrisch in einer Serienschaltung mit der Serienschaltung aus resistivem Messelement (103, 203, 303) und induktivem Messelement (104, 204, 304) angeordnet ist, um bei Erkennen eines Kurzschlusses den Stromfluss in der Serienschaltung zu unterbrechen.

13. Verfahren nach Anspruch 12, wobei in der steuerbaren Schalteinrichtung (213, 313) eine Anzahl von halbleiterbasierten Schalteinheiten angesteuert werden, welche jeweils einen Leistungseingang und einen Leistungsausgang und einen Steuereingang aufweisen und deren Lastpfade (150) bei Vorhandensein mehrerer halbleiterbasierter Schalteinheiten elektrisch parallel zueinander angeordnet sind, insbesondere wobei die halbleiterbasierten Schalteinheiten mit einer vorgegebenen positiven Spannung (322) angesteuert werden, um die halbleiterbasierten Schalteinheiten zu schließen, und mit einer vorgegebenen negativen Spannung (323) angesteuert werden, um die halbleiterbasierten Schalteinheiten zu öffnen.

14. Verfahren zum Versorgen einer elektrischen Last (319) mit elektrischer Energie in einem Versorgungssystem (315), aufweisend:

a) Versorgen (S31) der elektrischen Last (319) aus einer Energiequelle (316), und
b) Öffnen (S32) des Lastpfads (150) bei Auftreten eines Kurzschlusses in dem Lastpfad (150) mit einem Verfahren gemäß einem der Ansprüche 12 und 13.

15. Verfahren nach Anspruch 14, wobei der Betrag der negativen Spannung (323) derart gewählt wird, dass er größer ist, als der Betrag eines durch eine Systeminduktivität des Versorgungssystems (315) in dem Versorgungssystem (315) erzeugten Spannungsanstiegs an den Leistungseingängen und Steuereingängen der halbleiterbasierten Schalteinheiten.

Fig. 1

Fig. 2

Fig. 3

Fig. 4

Fig. 5

Fig. 6

**Europäisches Patentamt**

**European Patent Office**

**Office européen des brevets**

# EUROPÄISCHER RECHERCHENBERICHT

Nummer der Anmeldung

EP 19 18 0420

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 473 428 A2 (WESTINGHOUSE ELECTRIC CORP [US]) 4. März 1992 (1992-03-04) * Spalte 1, Zeile 1 - Spalte 3, Zeile 58 * * Abbildungen 1,2 * ----- | 1-15 | INV. G01R19/165 G01R31/02 H02H3/44 |
| X | US 2016/301200 A1 (NIEHOFF RONALDUS [NL]) 13. Oktober 2016 (2016-10-13) * Abbildung 1 * * Absätze [0010], [0055] * * Absatz [0016] - Absatz [0032] * ----- | 1,4,5,9, 12,13 | |

**RECHERCHIERTE SACHGEBIETE (IPC)**

G01R
H02H

Der vorliegende Recherchenbericht wurde für alle Patentansprüche erstellt

| Recherchenort | Abschlußdatum der Recherche | Prüfer |
|---|---|---|
| München | 26. November 2019 | Sedlmaier, Stefan |

**ANHANG ZUM EUROPÄISCHEN RECHERCHENBERICHT
ÜBER DIE EUROPÄISCHE PATENTANMELDUNG NR.**

EP 19 18 0420

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-11-2019

| Im Recherchenbericht angeführtes Patentdokument | Datum der Veröffentlichung | Mitglied(er) der Patentfamilie | Datum der Veröffentlichung |
|---|---|---|---|
| EP 0473428 A2 | 04-03-1992 | CA 2049120 A1 | 01-03-1992 |
| | | CN 1059429 A | 11-03-1992 |
| | | EP 0473428 A2 | 04-03-1992 |
| | | JP H04244724 A | 01-09-1992 |
| | | KR 920005205 A | 28-03-1992 |
| | | US 5181155 A | 19-01-1993 |
| US 2016301200 A1 | 13-10-2016 | CN 105934858 A | 07-09-2016 |
| | | EP 3078093 A1 | 12-10-2016 |
| | | GB 2520961 A | 10-06-2015 |
| | | US 2016301200 A1 | 13-10-2016 |
| | | WO 2015082632 A1 | 11-06-2015 |

EPO FORM P0461

Für nähere Einzelheiten zu diesem Anhang : siehe Amtsblatt des Europäischen Patentamts, Nr.12/82